# EUROPÄISCHE PATENTSCHRIFT

(11) **EP 0 656 590 B1**
(45) Veröffentlichungstag und Bekanntmachung des Hinweises auf die Patenterteilung: **13.02.2002**
(21) Anmeldenummer: 94203457.0
(22) Anmeldetag: 29.11.1994
(51) Int. Cl.: G06F 11/267, G01R 31/04, G01R 31/3185

(54) **Messvorrichtung zum Testen der Verbindungen zwischen wenigstens zwei Baugruppen**
Measuring device to test the connection between at least two subassemblies
Dispositif de mesure pour tester la connexion entre an moins deux sous-groupes

(30) Priorität: 01.12.1993 DE 4340899
(43) Veröffentlichungstag der Anmeldung: 07.06.1995
(73) Patentinhaber: Philips Corporate Intellectual Property GmbH, 52064 Aachen (DE); Koninklijke Philips Electronics N.V., 5621 BA Eindhoven (NL)
(72) Erfinder: Meyer, Gerhard Dipl.-Ing., D-20097 Hamburg (DE)
(74) Vertreter: Volmer, Georg, Dipl.-Ing.

(56) Entgegenhaltungen:
- EP-A- 0 382 184
- EP-A- 0 492 118
- US-A- 4 860 290

## Beschreibung

Die Erfindung bezieht sich auf eine Meßvorrichtung wenigstens zum Testen der Verbindungen zwischen wenigstens zwei Baugruppen mit einer Testanordnung zur Erzeugung eines an einen Testanordnungsausgang gelieferten Testsignals und zur Auswertung eines von einer Baugruppe gelieferten, aus dem Testsignal gebildeten und an einem Testanordnungseingang empfangenen Analysesignals.

Eine solche Meßvorrichtung ist beispielsweise aus der US-Patentschrift 5,029,166 bekannt, die eine Testanordung zur Erzeugung eines Testsignals (TDI), eines Testtaktsignals (TCK) und eines Teststeuersignals (TMS) und zum Empfang eines Analysesignals (TDO) enthält. Mittels dieser Meßvorrichtung wird ein Boundary-Scan-Test durchgeführt. Hierbei sind beispielsweise vor den Eingängen von zu testenden Schaltungsanordnungen Boundary-Scan-Zellen angeordnet, welche entweder direkt oder abgeleitete Testsignale empfangen. In den Boundary-Scan-Zellen kann eine Verknüpfung von Testsignalen und Eingangssignalen stattfinden. Die Boundary-Scan-Zellen sind in Reihe geschaltet und die letzte Boundary-Scan-Zelle gibt ein Zwischensignal oder ein Analysesignal ab. Ein Analysesignal wird direkt zur Testanordnung gegeben. Das Zwischensignal wird der nächsten Boundary-Scan-Zellenanordnung zugeführt. Mit dieser Meßvorrichtung lassen sich einzelne Schaltungsanordnungen oder auch Verbindungen zwischen den Schaltungsanordnungen oder Baugruppen testen.

Die Verbindungen von Baugruppen können getestet werden, wenn die einzelnen Baugruppen für den Test oder die Messung ringförmig zusammengeschaltet sind. Dabei ist ein Baugruppen-Testeingang entweder mit einem Testanordnungsausgang oder einem Baugruppen-Testausgang einer anderen Baugruppe verbunden. Wenn die Verbindungen von Baugruppen in einem System getestet werden sollen, müssen alle Baugruppen des Systems vorhanden und funktionsfähig sein. Eine solche Ringkonfiguration läßt sich beim Aufbau des Systems oder bei einem modularen System (z.B. in der Telekommunikationstechnik) ohne weitere Hilfsmaßnahmen nicht verwenden.

Eine weitere Möglichkeit besteht in der Verwendung einer Sternstruktur für den Test von Baugruppen eines Systems. Hierbei wird jedoch für jede Baugruppe eine eigene Steuerverbindung für ein jeder Baugruppe zugeordnetes Teststeuersignal benötigt.

Der Erfindung liegt daher die Aufgabe zugrunde, eine Meßvorrichtung zu schaffen, die bei modularen Systemen ohne größeren Aufwand einen Test von Verbindungen zwischen den Baugruppen des Systems ermöglicht.

Die Aufgabe wird bei einer Meßvorrichtung der eingangs genannten Art dadurch gelöst,
daß die Testanordnung auch zur Zuführung eines Schaltsteuersignals zu auf einer Baugruppe enthaltenen Steueranordnung vorgesehen ist,
daß eine Baugruppe eine von der zugeordneten Steueranordnung gesteuerte Schaltvorrichtung enthält, die zur Weiterleitung eines Testsignals oder eines aus dem Testsignal gebildeten Zwischensignals an einen Baugruppen-Testeingang und zum Empfang wenigstens eines weiteren Zwischensignals von einem Baugruppen-Testausgang vorgesehen ist, und
daß eine Schaltvorrichtung in einem ersten Schaltzustand zur Kopplung des Baugruppen-Testeingangs mit dem Testanordnungsausgang und des Baugruppen-Testausgangs mit einer Hilfsverbindung und in einem zweiten Schaltzustand zur Kopplung des Baugruppen-Testeingangs mit einer Hilfsverbindung und des Baugruppen-Testausgangs mit dem Testanordnungseingang vorgesehen ist.

Die zu testenden oder zu messenden Baugruppen enthalten zusätzlich eine Schaltvorrichtung, die außer einer Verbindung zu der Testanordnung auch eine Hilfsverbindung zu wenigstens einer anderen Baugruppe aufweist. Die Schaltvorrichtung wird von einer Steueranordnung gesteuert, die bei komplexen Baugruppen, wie z.B. in der Telekommunikation, schon vorhanden sind. Die Steuerung wird dabei in Abhängigkeit vom Schaltsteuersignal durchgeführt. Eine Schaltvorrichtung koppelt in einem ersten Schaltzustand einen Baugruppen-Testeingang mit dem Testanordnungsausgang, der das Testsignal liefert, und den zugehörigen Baugruppen-Testausgang mit der Hilfsverbindung. Wenn eine Schaltvorrichtung einer ersten Baugruppe in einem ersten Schaltzustand ist, weist eine Schaltvorrichtung einer zweiten Baugruppe einen zweiten Schaltzustand auf. Hierbei koppelt die Schaltvorrichtung der zweiten Baugruppe ihren Baugruppen-Testeingang mit der Hilfsverbindung oder mit einer weiteren Hilfsverbindung, wenn die Verbindungen einer zwischengeschalteten, dritten Baugruppe ebenfalls gemessen werden sollen, und ihren Baugruppen-Testausgang mit dem Testanordnungseingang. Die Schaltvorrichtung der dritten Baugruppe stellt einerseits eine Kopplung zwischen der ersten Hilfsverbindung und dem zugehörigen Baugruppen-Testeingang und andererseits eine Kopplung zwischen der zweiten Hilfsverbindung und dem Baugruppen-Testausgang her. Möglich wäre auch die weitere Einfügung von Baugruppen. Dann müßten weitere Hilfsverbindungen durchgerührt werden.

Mit der erfindungsgemäßen Meßvorrichtung wird ein Test oder eine Messung von Verbindungen zwischen Baugruppen ermöglicht, bei der die Verbindungen für die einzelnen Signale durch eine Schaltvorrichtung auf den Baugruppen individuell hergestellt werden. So können auch modulare Systeme getestet werden, ohne daß weitere Leitungen für Teststeuersignale erforderlich sind.

Wenn eine Schaltungsanordnung auf einer Baugruppe getestet werden soll, wechselt die Schaltvorrichtung in einem dritten Schaltzustand. Hierbei wird der Baugruppen-Testeingang mit dem Testanordnungsausgang und der Baugruppen-Testausgang mit dem Testanordnungseingang gekoppelt.

Die Schaltvorrichtung einer nicht zu testenden Baugruppe wechselt in einem vierten Schaltzustand. Im vierten Schaltzustand ist zwischen dem Baugruppen-Testeingang und dem Testanordnungsausgang und zwischen dem Baugruppen-Testausgang und dem Testanordnungseingang keine Kopplung vorgesehen.

Die Testanordnung enthält zur Erzeugung eines Testsignals und eines Testtaktsignals einen Testgenerator und noch eine Auswerteschaltung. Die Auswerteschaltung erzeugt ein den Baugruppen zuzuführendes, einen Testvorgang angebendes Teststeuersignals und wertet ein Analysesignal aus. Das Teststeuersignal gibt beispielsweise an, welcher Art von Test durchgeführt wird und wie einzelne Schaltelemente zur Durchführung des Tests auf einer Baugruppe arbeiten sollen. Weiter dient die in Abhängigkeit vom Schaltsteuersignal gesteuerte Schaltvorrichtung einer Baugruppe im ersten, zweiten und dritten Schaltzustand zur Zuführung des Testtaktsignals zu den Schaltungsanordnungen der Baugruppe.

Wie oben erwähnt führen die Steueranordnungen auf einer Baugruppe auch andere Steuervorgänge im Normalbetrieb durch. Da solche Steueranordnungen in der Regel über ein Bussystem miteinander gekoppelt sind, ist die Auswerteschaltung mit einem solchen Bus auf einfache Weise koppelbar. Der Bus dient also nicht nur zur Übertragung eines Schaltsteuersignals.

Eine neue Baugruppe kann auf einfache Weise in das System eingefügt werden, wenn das Testsignal, das Testtaktsignal, das Teststeuersignal und das Zwischensignal über jeweils busähnlich angeordnete Leitungen übertragen werden.

Ferner bezieht sich die Erfindung auf eine Baugruppe, die zum Empfang eines von einer Testanordnung über einen Testanordnungsausgang zu lieferden Testsignals oder eines Zwischensignals von einer anderen Baugruppe und zur Zuführung eines weiteren Zwischensignals an eine weitere Baugruppe oder eines aus dem Testsignal gebildeten und einem Testanordnungseingang zu liefernden Analysesignals vorgesehen ist. Hierbei ist eine Steueranordnung auf der Baugruppe zum Empfang eines Schaltsteuersignals von der Testanordnung angeordnet. Eine von der zugeordneten Steueranordnung gesteuerte Schaltvorrichtung ist ebenfalls auf der Baugruppe enthalten, die zur Weiterleitung eines Testsignals oder eines aus dem Testsignal gebildeten Zwischensignals an einen Baugruppen-Testeingang und zum Empfang wenigstens eines weiteren Zwischensignals von einem Baugruppen-Testausgang vorgesehen ist. Die Schaltvorrichtung ist in einem ersten Schaltzustand zur Kopplung des Baugruppen-Testeingangs mit dem Testanordnungsausgang und des Baugruppen-Testausgangs mit einer Hilfsverbindung und in einem zweiten Schaltzustand zur Kopplung des Baugruppen-Testeingangs mit einer Hilfsverbindung und des Baugruppen-Testausgangs mit dem Testanordnungseingang oder mit einer weiteren Hilfsverbindung vorgesehen.

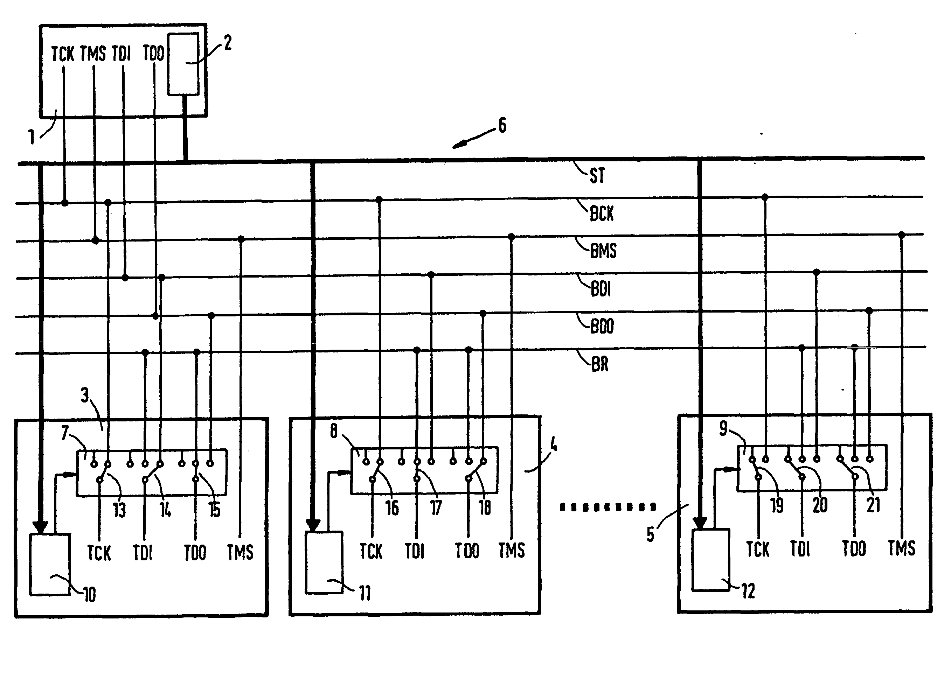

Ein Ausführungsbeispiel der Erfindung wird nachstehend anhand der Figur erläutert, die eine Meßvorrichtung zum Testen der Verbindungen zwischen wenigstens zwei Baugruppen und zum Test einer Schaltungsanordnung auf einer Baugruppe zeigt.

Die in der Fig. gezeigte Meßvorrichtung enthält eine Testanordnung 1 mit einer Auswerteschaltung 2, die beispielsweise als Mikroprozessor oder Signalprozessor realisiert sein kann, und einen nicht näher dargestellten Taktgenerator. Mit Hilfe der Testanordnung 1 kann ein Boundary-Scan-Test von Baugruppen 3, 4 und 5 durchgeführt werden. Hierzu werden den Baugruppen 3, 4 und 5 ein Testtaktsignal TCK, ein Teststeuersignal TMS und ein Testsignal TDI von der Testanordnung 1 zugeführt. Wenn das Testsignal, das beispielsweise in der Testanordnung 1 generiert wird, eine oder mehrere Baugruppen 3, 4 und 5 durchlaufen hat, wird ein Analysesignal TDO empfangen, das von der Auswerteschaltung 2 ausgewertet wird und angibt, ob das System oder die Baugruppen korrekt arbeiten. Das Testsignal TDI kann eine Testfolge liefern, die direkt den einzelnen Boundary-Scan-Zellen in einer Baugruppe 3, 4 oder 5 oder einer Schaltungsanordnung auf der Baugruppe 3, 4 oder 5 zugeführt wird oder in einer Umsetzerschaltung auf einer Baugruppe 3, 4 oder 5 umgesetzt wird. Das Teststeuersignal TMS gibt beispielsweise an, um welchen Test es sich handelt.

Die Testanordnung 1 ist über ein Bussystem 6 mit den Baugruppen 3, 4 und 5 gekoppelt. Jede Baugruppe 3, 4 und 5 enthält außer den für bestimmte Funktion der Baugruppe vorgesehenen Schaltungsanordnungen eine zusätzliche Schaltvorrichtung 7, 8 und 9. Diese Schaltvorrichtung wird von einer Steueranordnung 10, 11 und 12 gesteuert, die im normalen Betrieb auf der Baugruppe 3, 4 und 5 auch andere Funktionen durchführt und beispielsweise als Mikroprozessor oder Signalprozessor ausgebildet ist. Die Steueranordnungen 10, 11 und 12 sind über Leitungen ST des Bussystems 6 miteinander und mit der Auswerteschaltung 2 gekoppelt. Über die Leitungen ST des Bussystems 6 wird den Steueranordnungen 10, 11 und 12 ein Schaltsteuersignal von der Auswerteschaltung 2 geliefert.

Ferner enthält das Bussystem 6 eine Leitung BCK, auf der das Testtaktsignal TCK übertragen wird. Das Teststeuersignal TMS wird auf eine Leitung BMS des Bussystems 6 gegeben. Das Testsignal TDI wird einer Leitung BDI und das Analysesignal TDO einer Leitung BDO des Bussystems 6 zugeführt. Im Bussystem 6 ist noch eine Hilfsleitung BR vorhanden, die mindestens eine Hilfsverbindung zwischen zwei Baugruppen ermöglicht.

Im folgenden wird die Funktion einer Schaltvorrichtung 7, 8 oder 9 an der Schaltvorrichtung 7 näher beschrieben. Die Schaltvorrichtung 7 enthält drei einzelne Schalter 13, 14 und 15, die über das Bussystem 6 zugeführte Signale zur Baugruppe 3 weiterleiten. Der erste Schalter 13 in der Schaltvorrichtung 7 kann eine Verbindung mit der Busleitung BCK herstellen oder in eine Ruhestellung gehen. Wenn der Schalter 13 nicht in einer Ruhestellung ist, leitet er das Testtaktsignal TCK zu Schaltungsanordnungen der Baugruppe 3 weiter. Der zweite Schalter 14 in der Schaltvorrichtung 7 dient zur Herstellung einer Verbindung entweder zwischen der Busleitung BDI oder der Hilfsleitung BR. Auch dieser Schalter 14 kann in eine Ruhestellung gehen, in der keine Verbindung mit einer Busleitung besteht. Wenn der Schalter 14 nicht in einer Ruhestellung ist, liefert er an einen Baugruppen-Testeingang der Baugruppe 3 entweder ein Testsignal TDI von einem Testanordnungsausgang der Testanordnung 1 oder empfängt ein abgeleitetes Testsignal von einer anderen Baugruppe 4 oder 5 über die Hilfsleitung BR des Bussystems 6. Der Schalter 15 kann eine Verbindung mit der Busleitung BDO und eine Verbindung mit der Hilfsleitung BR herstellen. Auch der Schalter 15 weist eine Ruhestellung auf. Ein Testsignal, das beispielsweise Schaltungsanordnungen der Baugruppe 3 durchlaufen hat, wird über einen Baugruppen-Testausgang der Baugruppe 3 über den Schalter 15 zu der Hilfsleitung BR des Bussystems 6 oder über die Busleitung BDO zum Testanordnungseingang der Testanordnung 1 geführt.

Die Schaltvorrichtungen 8 und 9 weisen ebenfals jeweils drei Schalter 16, 17 und 18 bzw. 19, 20 und 21 auf. Diese Schalter 16, 17 und 18 bzw. 19, 20 und 21 arbeiten auf die gleiche Weise wie die Schalter 13, 14 und 15 der Schaltvorrichtung 7.

Wenn eine Schaltungsanordnung oder mehrere Schaltungsanordnungen auf einer Baugruppe 3, 4 oder 5 gemessen oder getestet werden sollen, leitet der Schalter 13 das Taktsignal zu einer oder mehreren Schaltungsanordnungen der Baugruppe 3, 4 oder 5 weiter. Der Schalter 14 liefert beispielsweise ein Testsignal TDI über die Busleitung BDI zum Baugruppen-Testeingang der Baugruppe 3. Daß die Baugruppe 3 durchlaufende Testsignal wird als Analysesignal über den Schalter 15 der Schaltvorrichtung 7 zur Busleitung BDO geleitet. In diesem Fall ist die Schaltvorrichtung in einem dritten Schaltzustand. Die anderen Schalter 16, 17 und 18 bzw. 19, 20 und 21 der Schaltvorrichtungen 8 und 9 sind in einer Ruhestellung (vierter Schaltzustand).

Bei einem Test oder einer Messung von Verbindungen zwischen zwei Baugruppen, beispielsweise den Baugruppen 3 und 4, empfängt beispielsweise die Baugruppe 3 über den Schalter 14 das Testsignal TDI. Das die Baugruppe durchlaufende Testsignal wird als Zwischensignal über den Schalter 15 der Schaltvorrichtung 7 zur Hilfsleitung BR des Bussystems 6 gegeben. Die Schaltvorrichtung 7 ist in diesem Fall in einem ersten Schaltzustand. Der Schalter 17 der Testvorrichtung 8 (Baugruppe 4) leitet das Zwischensignal von der Hilfsleitung BR zum Baugruppen-Testeingang der Baugruppe 4. Dieses die verschiedenen Schaltungsanordnungen der Baugruppe 4 durchlaufende Zwischensignal wird als Analysesignal über den Schalter 18 der Schaltvorrichtung 8 zur Busleitung BDO gegeben und nach Empfang in dem Testgenerator 1 ausgewertet. Hier ist die Schaltvorrichtung 8 in einem zweiten Schaltzustand. Die Schalter 19, 20 und 21 der anderen Schaltvorrichtung 9 sind in Ruhestellung (vierter Schaltzustand).

Das Testtaktsignal TCK wird nur im vierten Schaltzustand nicht zu Schaltungsanordnungen der Baugruppen 3, 4 und 5 geführt. Das Teststeuersignal TMS weist eine direkte Verbindung mit Schaltungsanordnungen der Baugruppen 3, 4 und 5 auf.

## Patentansprüche

1. Meßvorrichtung wenigstens zum Testen der Verbindungen zwischen wenigstens zwei Baugruppen (3, 4, 5) mit einer Testanordnung (1) zur Erzeugung eines an einen Testanordnungsausgang gelieferten Testsignals und zur Auswertung eines von einer Baugruppe (3, 4, 5) gelieferten, aus dem Testsignal gebildeten und an einem Testanordnungseingang empfangenen Analysesignals,
**dadurch gekennzeichnet,**
**daß** die Testanordnung (1) auch zur Zuführung eines Schaltsteuersignals zu auf einer Baugruppe (3, 4, 5) enthaltenen Steueranordnung (10, 11, 12) vorgesehen ist,
**daß** eine Baugruppe (3, 4, 5) eine von der zugeordneten Steueranordnung (10, 11, 12) gesteuerte Schaltvorrichtung (7, 8, 9) enthält, die zur Weiterleitung eines Testsignals oder eines aus dem Testsignal gebildeten Zwischensignals an einen Baugruppen-Testeingang und zum Empfang wenigstens eines weiteren Zwischensignals von einem Baugruppen-Testausgang vorgesehen ist, und
**daß** eine Schaltvorrichtung (7, 8, 9) in einem ersten Schaltzustand zur Kopplung des Baugruppen-Testeingangs mit dem Testanordnungsausgang und des Baugruppen-Testausgangs mit einer Hilfsverbindung (BR) und in einem zweiten Schaltzustand zur Kopplung des Baugruppen-Testeingangs mit einer Hilfsverbindung (BR) und des Baugruppen-Testausgangs mit dem Testanordnungseingang vorgesehen ist.

2. Meßvorrichtung nach Anspruch 1,
**dadurch gekennzeichnet,**
**daß** zum Testen wenigstens einer Schaltungsanordnung auf einer Baugruppe (3, 4, 5) die Schaltvorrichtung (7, 8, 9) in einem dritten Schaltzustand zur Kopplung des Baugruppen-Testeingangs mit dem Testanordnungsausgang und des Baugruppen-Testausgangs mit dem Testanordnungseingang vorgesehen ist.

3. Meßvorrichtung nach Anspruch 1 oder 2,
**dadurch gekennzeichnet,**
**daß** die Schaltvorrichtung (7, 8, 9) einer nicht zu testenden Baugruppe (3, 4, 5) in einem vierten Schaltzustand keine Kopplung zwischen dem Baugruppen-Testeingang und dem Testanordnungsausgang und zwischen dem Baugruppen-Testausgang und dem Testanordnungseingang vorgesehen ist.

4. Meßvorrichtung nach Anspruch 1, 2 oder 3,
**dadurch gekennzeichnet,**
**daß** die Testanordnung (1) zur Erzeugung eines Testsignals und eines Testtaktsignals einen Testgenerator enthält,
**daß** die Testanordnung (1) zur Erzeugung eines den Baugruppen (3, 4, 5) zuzuführenden, einen Testvorgang angebenden Teststeuersignals und zur Auswertung eines Analysesignals eine Auswerteschaltung (2) enthält und
**daß** die in Abhängigkeit vom Schaltsteuersignal gesteuerte Schaltvorrichtung (7, 8, 9) einer Baugruppe (3, 4, 5) im ersten, zweiten und dritten Schaltzustand zur Zuführung des Testtaktsignals zu den Schaltungsanordnungen der Baugruppe (3, 4, 5) vorgesehen ist.

5. Meßvorrichtung nach einem der Ansprüche 1 bis 4,
**dadurch gekennzeichnet,**
**daß** die Steueranordnung (10, 11, 12) auf einer Baugruppe (3, 4, 5) nicht nur zur Steuerung der zugeordneten Schaltvorrichtung (7, 8, 9) vorgesehen ist und
**daß** die Steueranordnungen (10, 11, 12) der Baugruppen (3, 4, 5) und die Auswerteschaltung (2) über Busleitungen (6) miteinander gekoppelt sind, die nicht nur zur Übertragung eines Schaltsteuersignals vorgesehen sind.

6. Meßvorrichtung nach einem der Ansprüche 1 bis 5,
**dadurch gekennzeichnet,**
**daß** das Testsignal, das Testtaktsignal, das Teststeuersignal und das Zwischensignal über jeweils busähnlich angeordnete Leitungen (6) übertragen werden.

7. Baugruppe (3, 4, 5), die zum Empfang eines von einer Testanordnung (1) über einen Testanordnungsausgang zu lieferden Testsignals oder eines Zwischensignals von einer anderen Baugruppe (3, 4, 5) und zur Zuführung eines weiteren Zwischensignals an eine weitere Baugruppe (3, 4, 5) oder eines aus dem Testsignal gebildeten und einem Testanordnungseingang zu liefernden Analysesignals vorgesehen ist,
**dadurch gekennzeichnet,**
**daß** eine Steueranordnung (10, 11, 12) zum Empfang eines Schaltsteuersignals von der Testanordnung (1) angeordnet ist,
**daß** eine von der zugeordneten Steueranordnung (10, 11, 12) gesteuerte Schaltvorrichtung (7, 8, 9) angeordnet ist, die zur Weiterleitung eines Testsignals oder eines aus dem Testsignal gebildeten Zwischensignals an einen Baugruppen-Testeingang und zum Empfang wenigstens eines weiteren Zwischensignals von einem Baugruppen-Testausgang vorgesehen ist, und
**daß** die Schaltvorrichtung (7, 8, 9) in einem ersten Schaltzustand zur Kopplung des Baugruppen-Testeingangs mit dem Testanordnungsausgang und des Baugruppen-Testausgangs mit einer Hilfsverbindung (BR) und in einem zweiten Schaltzustand zur Kopplung des Baugruppen-Testeingangs mit einer Hilfsverbindung (BR) und des Baugruppen-Testausgangs mit dem Testanordnungseingang vorgesehen ist.

## Claims

1. A measuring device used at least for testing the connections between at least two subassemblies (3, 4, 5), comprising a test system (1) for generating a test signal available on an output of the test system and for evaluating an analysis signal produced by a subassembly (3, 4, 5) from the test signal and received on an input of the test system, **characterized in that** the test system (1) is also provided for applying a switch control signal to a controller (10, 11, 12) included in a subassembly (3, 4, 5), **in that** a subassembly (3, 4, 5) includes a switching circuit (7, 8, 9) controlled by the assigned controller (10, 11, 12), which switching circuit is provided for directing a test signal or an intermediate signal formed from this test signal to a test input of a subassembly and for receiving at least a further intermediate signal from a test output of a subassembly, and **in that** a switching circuit (7, 8, 9) in a first position is provided for coupling the test input of the subassembly to the output of the test system and for coupling the test output of the subassembly to an auxiliary line (BR), and in a second position of the switching circuit, for coupling the test input of the subassembly to an auxiliary line (BR) and for coupling the test output of the subassembly to the input of the test system.

2. A measuring device as claimed in Claim 1, **characterized in that** for testing at least one circuit arrangement in a subassembly (3, 4, 5), the switching circuit (7, 8, 9) in a third position is provided for coupling the test input of the subassembly to the output of the test system and for coupling the test output of the subassembly to the input of the test system.

3. A measuring device as claimed in Claim 1 or 2, **characterized in that** there is no coupling between the test input of the subassembly (3, 4, 5) and the output of the test system and between the test output of the subassembly and the input of the test system if the switching circuit (7, 8, 9) of a subassembly not to be tested is in a fourth position.

4. A measuring device as claimed in Claim 1, 2 or 3, **characterized in that** the test system (1) includes a test generator for generating a test signal and a test clock signal, **in that** the test system (1) includes an evaluation circuit (2) for generating a test control signal to be transported to the subassembly (3, 4, 5) and denoting a test operation and for evaluating an analysis signal, and **in that** the switching circuit (7, 8, 9) of a subassembly (3, 4, 5) which switching circuit is controlled in response to the switch control signal is used in the first, second and third switching positions to apply the test clock signal to the circuit arrangements of the subassemblies (3, 4, 5).

5. A measuring device as claimed in one of the Claims 1 to 4, **characterized in that** the controller (10, 11, 12) in a subassembly (3, 4, 5) is not only provided for controlling the assigned switching circuit (7, 8, 9) and **in that** the controllers (10, 11, 12) of the subassemblies (3, 4, 5) and the evaluation circuit (2) are coupled to each other *via* bus lines (6) which are not used solely for transmitting a switch control signal.

6. A measuring device as claimed in one of the Claims 1 to 5, **characterized in that** the test signal, the test clock signal, the test control signal and the intermediate signal are transmitted by lines (6) having a similar structure to a bus.

7. A subassembly (3, 4, 5) arranged for receiving a test signal to be supplied by a test system (1) *via* an output of the test system, or an intermediate signal from another subassembly (3, 4, 5), and for applying a further intermediate signal to a further subassembly (3, 4, 5) or supplying an analysis signal formed from the test signal and to be applied to an input of the test system, **characterized in that** a controller (10, 11, 12) is arranged for receiving a switch control signal from the test system (1), **in that** a switching circuit (7, 8, 9) controlled by the assigned controller (10, 11, 12) is arranged, which switching circuit is provided for directing a test signal or an intermediate signal derived from the test signal to a test input of a subassembly and for receiving at least a further intermediate signal from a test output of a subassembly, and **in that** the switching circuit (7, 8, 9) in a first position is arranged for coupling the test input of the subassembly to the output of the test system and for coupling the test output of the subassembly to an auxiliary line (BR) and, in a second position, for coupling the test input of the subassembly to an auxiliary line (BR) and for coupling the test output of the subassembly to the input of the test system.

## Revendications

1. Dispositif de mesure au moins pour tester les connexions entre au moins deux sous-groupes (3, 4, 5) avec un dispositif de test (1) pour produire un signal de test délivré à une sortie du dispositif de test et pour évaluer un signal d'analyse délivré par un sous-groupe (3, 4 et 5), formé à partir du signal de test et reçu à une entrée du dispositif de test,
**caractérisé en ce**
**que** le dispositif de test (1) est prévu également pour amener un signal de commande de commutation à un dispositif de commande (10, 11, 12) contenu sur un sous-groupe (3, 4, 5),
**qu'**un sous-groupe (3, 4, 5) contient un dispositif de commutation (7, 8, 9) commandé par le dispositif de commande (10, 11, 12) affecté qui est prévu pour la transmission d'un signal de test ou d'un signal intermédiaire formé à partir du signal de test à une entrée de test de sous-groupes et pour la réception d'au moins un signal intermédiaire supplémentaire par une sortie de test de sous-groupes et
**qu'**un dispositif de commutation (7, 8, 9) est prévu, dans un premier état de commutation, pour la connexion de l'entrée de test de sous-groupes avec la sortie du dispositif de test et de la sortie de test de sous-groupes avec une connexion auxiliaire (BR) et, dans un deuxième état de commutation, pour la connexion de l'entrée de test de sous-groupes avec une connexion auxiliaire (BR) et de la sortie de test de sous-groupes avec l'entrée du dispositif de test.

2. Dispositif de mesure selon la revendication 1,
**caractérisé en ce**
**que** le dispositif de commutation (7, 8, 9) est prévu dans un troisième état de commutation pour le couplage de l'entrée de test de sous-groupes à la sortie du dispositif de test et de la sortie de test de sous-groupes à l'entrée du dispositif de test pour tester au moins un circuit sur un sous-groupe (3, 4, 5).

3. Dispositif de mesure selon l'une des revendications 1 ou 2,
**caractérisé en ce**
**que** le dispositif de commutation (7, 8, 9) d'un sous-groupe (3, 4, 5) à ne pas tester dans un quatrième état de commutation ne comporte pas de couplage entre l'entrée de test de sous-groupes et la sortie du dispositif de test et entre la sortie de test de sous-groupes et l'entrée du dispositif de test.

4. Dispositif de mesure selon l'une des revendications 1, 2 ou 3,
**caractérisé en ce**
**que** le dispositif de test (1) contient un générateur de test pour la production d'un signal de test et d'un signal de rythme de test,
**que** le dispositif de test (1) contient un circuit d'évaluation (2) pour produire un signal de commande de test à amener aux sous-groupes (3, 4 et 5) et indiquant la procédure de test et pour évaluer un signal d'analyse et
**que** le dispositif de commutation (7, 8, 9) d'un sous-groupe (3, 4, 5) commandé en fonction du signal de commande de commutation est prévu dans les premier, deuxième et troisième états de commutation pour amener le signal de rythme de test aux circuits du sous-groupe (3, 4 et 5).

5. Dispositif de mesure selon l'une des revendications 1 à 4,
**caractérisé en ce**
**que** le dispositif de commande (10, 11, 12) sur un sous-groupe (3, 4, 5) n'est pas prévu pour commander le dispositif de commutation (7, 8, 9) affecté et que les dispositifs de commande (10, 11, 12) des sous-groupes (3, 4, 5) et le circuit d'évaluation (2) sont couplés l'un à l'autre par l'intermédiaire des lignes de bus (6) qui ne sont pas prévues seulement pour la transmission d'un signal de commande de commutation.

6. Dispositif de mesure selon l'une des revendications 1 à 5,
**caractérisé en ce**
**que** le signal de test, le signal de rythme de test, le signal de commande de test et le signal intermédiaire sont transmis respectivement par l'intermédiaire de lignes (6) disposées à la manière d'un bus.

7. Sous-groupe (3, 4, 5) qui est prévu pour recevoir un signal de test à délivrer par un dispositif de test (1) par l'intermédiaire d'une sortie de dispositif de test ou d'un signal intermédiaire par un autre sous-groupe (3, 4, 5) et pour amener un signal intermédiaire supplémentaire à un autre sous-groupe (3, 4, 5) ou un signal d'analyse formé à partir du signal de test et à délivrer à une entrée du dispositif de test,
**caractérisé en ce**
**qu'**un dispositif de commande (10, 11, 12) est disposé pour recevoir un signal de commande de commutation par le dispositif de test (1),
**qu'**il est prévu un dispositif de commutation (7, 8, 9) commandé par le dispositif de commande (10, 11, 12) affecté qui est prévu pour transmettre un signal de test ou un signal intermédiaire formé à partir du signal de test à une entrée de test de sous-groupes et pour recevoir au moins un signal intermédiaire supplémentaire par une sortie de test de sous-groupes et
**que** le dispositif de commutation (7, 8, 9) est prévu dans un premier état de commutation pour coupler l'entrée de test de sous-groupes à la sortie du dispositif de test et de la sortie de test de sous-groupes à une connexion auxiliaire (BR) et, dans un deuxième état de commutation, pour coupler l'entrée de test de sous-groupes à une connexion auxiliaire (BR) et la sortie de test de sous-groupes à l'entrée du dispositif de test.
